(19) Europäisches Patentamt
European Patent Office
Office européen des brevets

(11) **EP 1 703 632 A1**

(12) **EUROPEAN PATENT APPLICATION**

(43) Date of publication:
20.09.2006 Bulletin 2006/38

(51) Int Cl.:
*H03B 5/36* (2006.01)          *H03K 3/03* (2006.01)

(21) Application number: 06005186.9

(22) Date of filing: 14.03.2006

(84) Designated Contracting States:
AT BE BG CH CY CZ DE DK EE ES FI FR GB GR
HU IE IS IT LI LT LU LV MC NL PL PT RO SE SI
SK TR
Designated Extension States:
AL BA HR MK YU

(30) Priority: 15.03.2005 JP 2005072606

(71) Applicant: Epson Toyocom Corporation
Saiwai-ku
Kawasaki-shi
Kanagawa 212-8513 (JP)

(72) Inventor: Satoh, Tomio,
c/o Epson Toycom Corporation
Kamiina-gun,
Nagano-ken 392-4696 (JP)

(74) Representative: HOFFMANN EITLE
Patent- und Rechtsanwälte
Arabellastrasse 4
81925 München (DE)

(54) **Piezoelectric oscillator**

(57)      A piezoelectric oscillator includes an inverter amplifier, a first load impedance constituting together with the inverter amplifier a connection circuit that is inserted between the power supply and the ground, a piezoelectric resonator being inserted between the input of the inverter amplifier and the ground, a second load impedance being serially inserted and connected between the input of the inverter amplifier and a connecting point of the inverter amplifier and the first load impedance, and a resistor being connected between the input and an output of the inverter amplifier.

FIG. 1

EP 1 703 632 A1

**Description**

BACKGROUND OF THE INVENTION

1. Technical Field

The present invention relates to a piezoelectric oscillator used for reference signal sources of computers, mobile communication devices, and the like and a piezoelectric oscillator used for mobile communication apparatuses and the like that require high-speed data transmission.

2. Related Art

Piezoelectric oscillators can provide stable oscillation frequency, and therefore have hitherto been broadly used as oscillators, for example, for clock oscillation sources of computers and for reference signal sources in mobile communication devices represented by cellular phones, transmission devices, and the like. Among them, in particular, piezoelectric oscillators (quartz crystal oscillators) using as the resonator quartz crystal, which is excellent in resonance characteristics and has high stability of frequency, are in heavy use for the aforementioned transmission devices and the like.

Description will be given below on a related art quartz crystal oscillator, taking as an example a quartz crystal oscillation circuit using a CMOS inverter amplifier that is in heavy use for clock sources and the like.

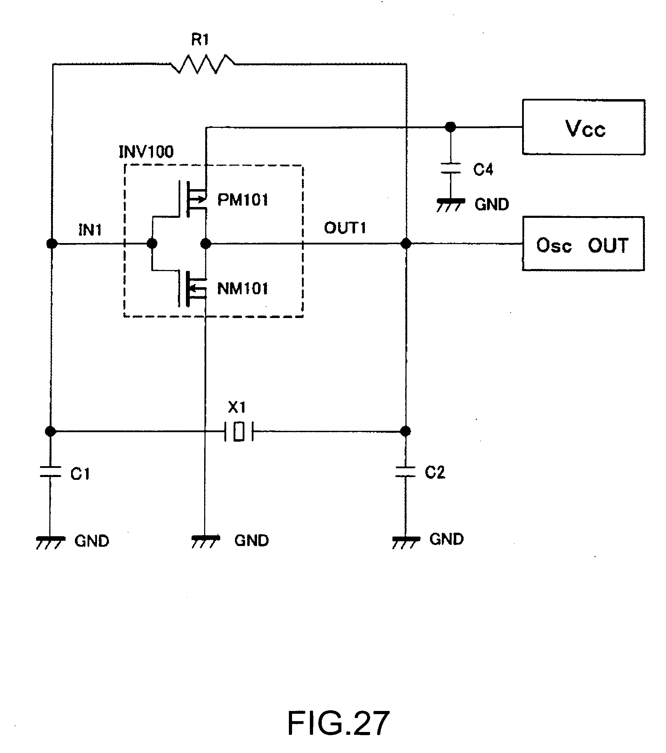

Fig. 27 illustrates a circuit diagram of a quartz crystal oscillator using a CMOS inverter amplifier. The quartz crystal oscillation circuit mentioned above is configured such that a quartz crystal resonator X1 is connected between input and output terminals of an inverter amplifier INV100, a feedback resistor R1 is connected in parallel to the quartz crystal resonator X1, the input IN1 of the inverter amplifier INV100 is grounded through a load capacitor C1, and the output OUT1 of the inverter amplifier INV100 is grounded through a load capacitor C2.

The inverter amplifier INV100 includes a P channel type MOS-FET (hereinafter referred to as a "P type MOS transistor") PM101 and an N channel type MOS-FET (hereinafter referred to as an "N type MOS transistor") NM101, the P type MOS transistor PM101 having the drain that is connected to a power supply voltage Vcc and a capacitor C4 connected between the power supply and the ground for removing high frequency components. The gate of the P type MOS transistor PM101 is connected to the gate of the N type MOS transistor NM101 to function as the input IN1 of an inverter amplifier INV101. The source of the p type MOS transistor PM101 is connected to the drain of the N type MOS transistor NM101 to function as the output OUT1 of the inverter amplifier INV101, and the source of the N type MOS transistor NM101 is grounded.

The inverter amplifier INV100 having such a structure as described above is a known CMOS inverter amplifier, and therefore operates as an inverting amplifier where the output signal is inverted or 180 degrees out of phase with the input signal to the gate. Accordingly, in the quartz crystal oscillation circuit, the quartz crystal resonator X1 connected between the input and output of the inverter amplifier INV100 functions as reactance (inductive) between the series resonance frequency and the parallel resonance frequency, thereby constituting together with the inverter amplifier INV100 and the load capacitors C1 and C2 a Colpitts oscillation circuit. Thus, an oscillation output that satisfies the oscillation conditions at the natural frequency of the quartz, crystal resonator X1 and has the oscillation frequency determined by the natural frequency of the quartz crystal resonator X1 can be obtained.

The quartz crystal oscillation circuit as described above has the simple circuit configuration and allows a stable oscillation output to be obtained easily, and therefore is in heavy use for various clock sources, digital circuits, and the like.

However, the configuration of the quartz crystal oscillation circuit using a CMOS inverter amplifier as described above has a problem as described below. In the related art circuit configuration, since a voltage having the maximum amplitude substantially equivalent to the supply voltage is applied to both ends of the quartz crystal resonator, a current (drive level) flowing in the quartz crystal resonator becomes very large. As a result, the quartz crystal resonator performing mechanical oscillations might age more and a parasitic oscillation in an unnecessary mode might be induced. Moreover, since the output is connected to the oscillation loop, frequency variations due to the effect of output load might be large.

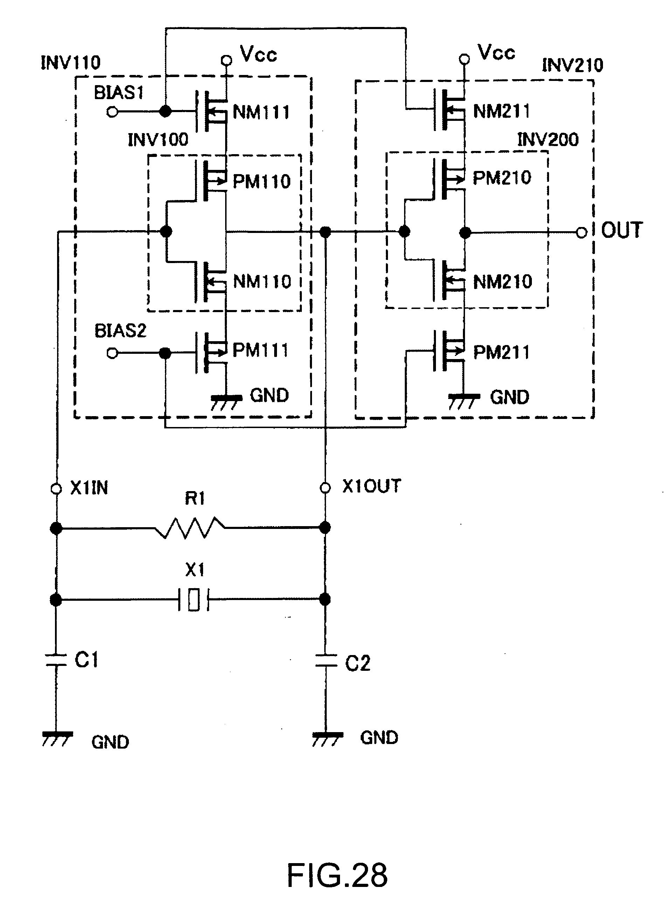

As the means to solve the problems as described above, JA-A-2003-110361, for example, is disclosed, which is an example of related art. The related art example includes the quartz crystal resonator X1 an inverting amplifier INV110 to excite the quartz crystal resonator X1, a buffer circuit INV210 to which the output of the inverting amplifier INV110 is inputted, a feedback resistor R1, and load capacitors C1 and C2, as shown in Fig. 28, wherein a parallel circuit including the quartz crystal resonator X1 and the feedback resistor R1 is connected between the input and output of the inverting amplifier INV110, the input of the inverting amplifier INV110 is grounded through the load capacitor C1, and the output of the inverting amplifier INV110 is grounded through the load capacitor C2, thereby configuring a quartz crystal oscillation circuit.

According to the related art example, the inverting amplifier INV110 includes an N type MOS transistor NM111 in which a current path is interposed on the supply path of the power supply voltage Vcc for the CMOS inverter INV100 and a first predetermined voltage BIAS1 is provided to the gate, and a P type MOS transistor PM111 in which a current path is interposed on the supply path of a predetermined ground voltage GND for the inverting amplifier INV100 and a second predetermined voltage BIAS2 is provided to the gate; while a CMOS inverter INV200 in the buffer circuit INV210 includes an N type MOS transistor NM211 in which the first predetermined voltage BIAS1 is provided to the gate and a P type MOS transistor PM211 in which the second predetermined voltage BIAS2 is provided to the gate. It is therefore possible to shift a predetermined power supply voltage and a predetermined ground voltage. Such effects makes it possible to obtain the gain of the inverting amplifier that satisfies the oscillation level under the condition that the drive level of the quartz crystal resonator is suppressed, thereby enabling prevention of deterioration of aging characteristics and abnormal oscillations in an unnecessary mode in the quartz crystal resonator.

Moreover, the provision of buffer circuit allows suppression of frequency variations due to the effect of output load.

The circuit configuration as disclosed in the above related art example, however, has the following problem. If the output of an inverting amplifier is connected to an oscillation loop, the frequency might significantly vary due to the effect of output load, and therefore a buffer circuit need be provided in the latter part of circuit as in the circuit described above. As a result, the total number of parts increases by the number of parts of the buffer circuit, and thus there has been a problem that reduction in size of the circuit is difficult.

SUMMARY

An aspect of the invention relates to a piezoelectric oscillator used for reference signal sources of computers, mobile communication devices, and the like and has an advantage to provide a piezoelectric oscillator capable of accommodating the needs for miniaturization in its simple configuration and suppressing the effect caused by the output load without a buffer circuit. Another aspect of the invention relates to a piezoelectric oscillator used for mobile communication apparatuses and the like requiring high-speed data transmission and has an advantage to provide a piezoelectric oscillator capable of accommodating the needs for miniaturization and low noise and taking out two output signals having a 180 degree phase difference.

According to an aspect of the invention, a piezoelectric oscillator includes an inverter amplifier having a CMOS structure including a P channel type MOS-FET and an N channel type MOS-FET connected in series, a first load impedance constituting together with the inverter amplifier a connection circuit that is inserted between the power supply and the ground, a piezoelectric resonator and a frequency adjustment means constituting a series circuit that is inserted between the input of the inverter amplifier and the ground, a second load impedance being connected between the input of the inverter amplifier and a connecting point of the inverter amplifier and the first load impedance, and a resistor being connected between the input and output of the inverter amplifier.

In this case, the first load impedance may include a parallel circuit having a load capacitor and a resistor, and the second load impedance may include a capacitor.

The first load impedance may include a parallel circuit having a load capacitor and an inductor, and the second load impedance may include a capacitor.

According to another aspect of the invention, a piezoelectric oscillator uses a pair of the above-described CMOS inverter amplifiers.

BRIEF DESCRIPTION OF THE DRAWINGS

The invention will be described with reference to the accompanying drawings, wherein like numbers refer to like elements.

Fig. 1 is a diagram showing a quartz crystal oscillation circuit according to a first embodiment of the invention.

Fig. 2 is a diagram showing a quartz crystal oscillation circuit according to a second embodiment of the invention.

Fig. 3 is a diagram showing an equivalent circuit at oscillation start-up in the first and second embodiments of the invention.

Fig. 4 is a diagram showing a modification of the quartz crystal oscillation circuit in the first and second embodiments of the invention.

Fig. 5 is a diagram showing a specific example using the quartz crystal oscillation circuit of the first embodiment of the invention.

Fig. 6 is a graph showing circuit negative resistance characteristics and circuit capacity characteristics with respect to oscillation frequency by means of simulation in the first embodiment of the invention.

Fig. 7 is a graph showing variable capacity characteristics and frequency variable characteristics with respect to frequency control voltage in the first embodiment of the invention.

Fig. 8 is diagram showing a specific example using the quartz crystal oscillation circuit of the second embodiment of the invention.

Fig. 9 is a graph showing circuit negative resistance characteristics and circuit capacity characteristics with respect to oscillation frequency by means of simulation in the second embodiment of the invention.

Fig. 10 is a graph showing variable capacity characteristics and frequency variable characteristics with respect to frequency control voltage in the second embodiment of the invention.

Fig. 11 is a diagram showing a modification of the example in Fig. 5.

Fig. 12 is a diagram showing a modification of the example in Fig. 8.

Fig. 13 is a diagram showing a quartz crystal oscillation circuit according to a third embodiment of the invention.

Fig. 14 is a diagram showing a quartz crystal oscillation circuit according to a fourth embodiment of the invention.

Fig. 15 is a diagram showing a modification of the quartz crystal oscillation circuit in the third and fourth embodiments of the invention.

Fig. 16 is a diagram showing an equivalent circuit at oscillation start-up in the third and fourth embodiments of the invention.

Fig. 17 is a diagram showing a specific example using the quartz crystal oscillation circuit of the third embodiment of the invention.

Fig. 18 is a diagram showing a modification of the example in Fig. 17.

Fig. 19 is a graph showing circuit negative resistance characteristics and circuit capacity characteristics with respect to oscillation frequency by means of simulation in the third embodiment of the invention.

Fig. 20 is a graph showing variable capacity characteristics and frequency variable characteristics with respect to frequency control voltage in the third embodiment of the invention.

Fig. 21 is a chart showing waveforms in the quartz crystal oscillation circuits shown in Figs. 17 and 18.

Fig. 22 is a diagram showing a specific example of the quartz crystal oscillation circuit of the fourth embodiment of the invention.

Fig. 23 is a diagram showing a modification of the example in Fig. 22.

Fig. 24 is a graph showing circuit negative resistance characteristics and circuit capacity characteristics with respect to oscillation frequency by means of simulation in the fourth embodiment of the invention.

Fig. 25 is a graph showing variable capacity characteristics and frequency variable characteristics with respect to frequency control voltage in the fourth embodiment of the invention.

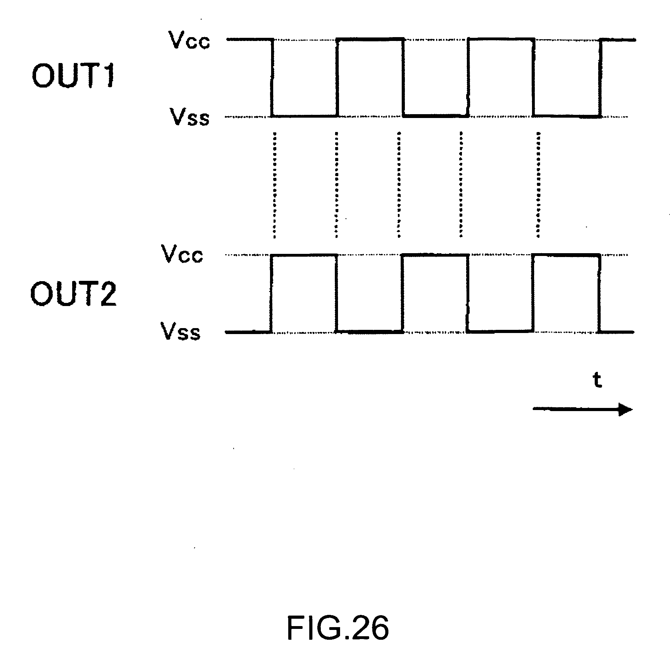

Fig. 26 is a chart showing waveforms in the quartz crystal oscillation circuits shown in Figs. 22 and 23.

Fig. 27 is a diagram showing a configuration example of a quartz crystal oscillator using a related art CMOS inverter amplifier.

Fig. 28 is a diagram showing another configuration example of a quartz crystal oscillator using a related art CMOS inverter amplifier.

## DESCRIPTION OF THE EMBODIMENTS

A piezoelectric oscillator according to some aspects of the invention includes an inverter amplifier with a CMOS structure and a first load impedance constituting a connection circuit that is inserted between the power supply and the ground, a piezoelectric resonator and a frequency adjustment means constituting a series circuit that is inserted between the input of the inverter amplifier and the ground, a second load impedance being connected between the input of the inverter amplifier and a connecting point of the inverter amplifier and the first load impedance, and a resistor being connected between the input and output of the inverter amplifier, thereby allowing the oscillation to operate with the drive level of the piezoelectric resonator suppressed. Frequency variations due to the effect of the output load can also be suppressed without a buffer circuit in the latter part of the oscillation circuit, enabling a small-sized quartz crystal oscillator to be configured in a simple structure.

Moreover, use of a pair of oscillation circuits including the above-described inverter amplifier makes it possible to provide a piezoelectric oscillator capable of taking out two signals that differ in their phases completely by 180 degrees from each other. Therefore, if a receiver driver with a common differential amplifier structure is used in the latter part of this oscillation circuit, it is also possible to provide, for example, a low noise oscillator from which common mode noise occurring in the oscillation circuit is removed.

First Embodiment

Detailed description on exemplary embodiments of the invention will now be described with reference to the accompanying drawings. Note that, in the following description and drawings related thereto, such components as are found in the related art example described above are indicated by the same reference numerals, and the same description will not be repeated.

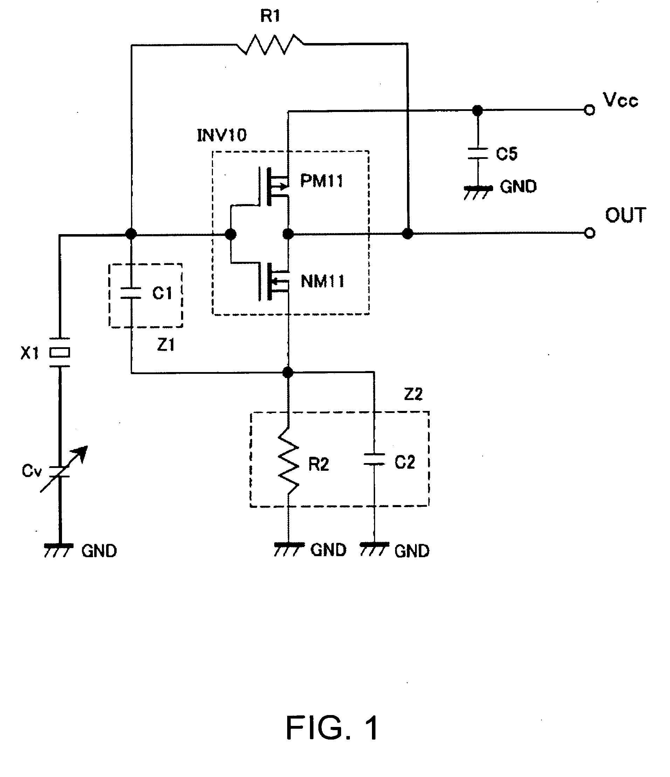

Fig. 1 shows a circuit diagram of a quartz crystal oscillator according to the first embodiment of the invention. The quartz crystal oscillation circuit is configured such that an inverter amplifier INV10 and a first load impedance Z2 constitute a connection circuit that is inserted between the power supply Vcc and the ground GND, the quartz crystal resonator X1 and a frequency adjustment circuit Cv of the quartz crystal oscillator constitute a series circuit that is inserted between the input of the inverter amplifier INV10 and the ground GND, a second load impedance Z1 is serially inserted and connected between the input of the inverter amplifier INV10 and the connecting point of the inverter amplifier INV10 and the first load impedance Z2, and further the resistor R1 is connected between the input and output of the inverter amplifier INV10.

The first load impedance Z2 includes a parallel circuit having a resistor R2 and the load capacitor C2, and the second load impedance Z1 includes the load capacitor C1. The inverter amplifier INV10 includes a P type MOS transistor PM11 and an N type MOS transistor NM11, wherein the drain of the P type MOS transistor PM11 is connected to the power supply Vcc and the capacitor C4 that is connected between the power supply Vcc and the ground GND and is used for removing high frequency components. The gate of the P type MOS transistor PM11 is connected to the gate of the N type MOS transistor NM11 and functions as the input IN1 of the inverter amplifier INV10. The source of the P type MOS transistor PM11 is connected to the drain of the N type MOS transistor NM11 and functions as the output OUT1 of the inverter amplifier INV10; the source of the N type MOS transistor NM11 is grounded.

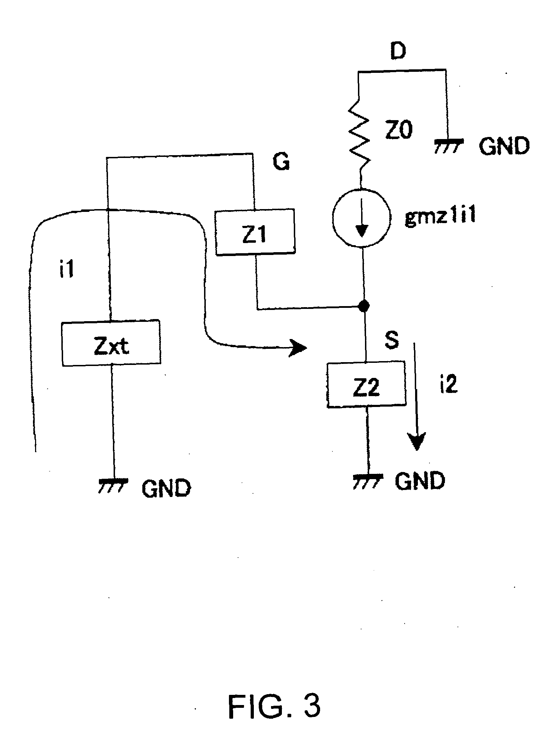

The principle of operation of the quartz crystal oscillation as described above will be described below. Fig. 3 illustrates an equivalent circuit where in the quartz crystal oscillation circuit shown in Fig. 1, the impedance in a series circuit of the quartz crystal resonator X1 and the frequency adjustment circuit Cv is Zxt, the current flowing through the impedances Zxt and Z1 is i1, and the current flowing through the second impedance Z2 is i2. When oscillation is started in the quartz crystal oscillation circuit shown in Fig. 1, a positive electric potential is applied between the gate and source of each of the N type MOS transistor NM11 and the P type MOS transistor PM11. Therefore, the N type MOS transistor NM11 functions as a constant current source gmZ1i1, and the P type MOS transistor PM11 can be regarded as a low impedance Z0 having a resistance of approximately 0. The inverter amplifier INV10 can thereby be replaced by a series circuit of the constant current source gmZ1i1 and the impedance Z0.

If Kirchhoff's law is applied in the circuit shown in Fig. 3, equations (1), (2), and (3) are obtained.

$$i_2 = i_1 + g_m z_1 i_1 \qquad (1)$$

$$z_{xt} i_1 + z_1 i_1 + z_2 (i_1 + g_m z_1 i_1) = 0 \quad (2)$$

$$z_{xt} + z_1 + z_2 + g_m z_1 z_2 = 0 \qquad (3)$$

The impedance between the gate and source of a MOS transistor is so high that it can be regarded as approximately $\infty$, and therefore the impedance of the circuit depends on Z1. Here, Z1 is the capacitive reactance C1 as can be seen from Fig. 1, and therefore can be represented by equation (4). At this point, Z2 also acts as capacitive reactance to have negative resistance. As shown in Fig. 1, Z2 includes the resistor R2 and capacitor C2 connected in parallel, and therefore the impedance of Z2 is expressed by equation (5).

$$z_1 = \frac{1}{j w c_1} \qquad (4)$$

$$z_2 = R_2 + \frac{1}{j w c_2} \qquad (5)$$

When equations (4) and (5) are substituted into equation (3), the following equation is obtained.

$$z_{xt} + R_2 - \frac{g_m}{w^2 c_1 c_2} + \frac{1}{j w}\left(\frac{1 + g_m R_2}{c_1} + \frac{1}{c_2}\right) = 0 \qquad (6)$$

At this point, if the impedance and the capacitive component of the circuit seen from the quartz crystal resonator X1 are Rc and Cc, respectively, the left side of equation (6) can be expressed by expression (7) and the Rc and Cc are expressed by equations (8) and (9).

$$z_{xt} + R_c + \frac{1}{jwC_c} \qquad (7)$$

$$R_c = R_2 - \frac{g_m}{w^2 C_1 C_2} \qquad (8)$$

$$\frac{1}{C_c} = \frac{1 + g_m R_2}{C_1} + \frac{1}{C_2} \qquad (9)$$

As known, for the oscillation conditions of the quartz crystal oscillation circuit, it is indispensable that the impedance of the circuit seen from the quartz crystal resonator includes the negative resistance component and capacitive component. Since expression (7) shows that the circuit shown in Fig. 1 satisfies the oscillation conditions, the circuit functions as the quartz crystal oscillation circuit.

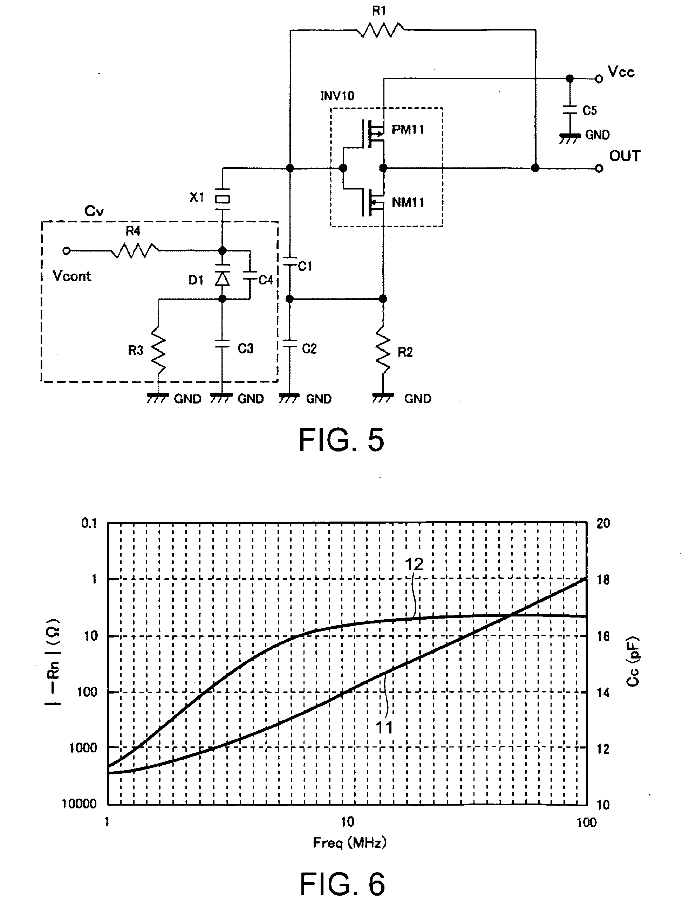

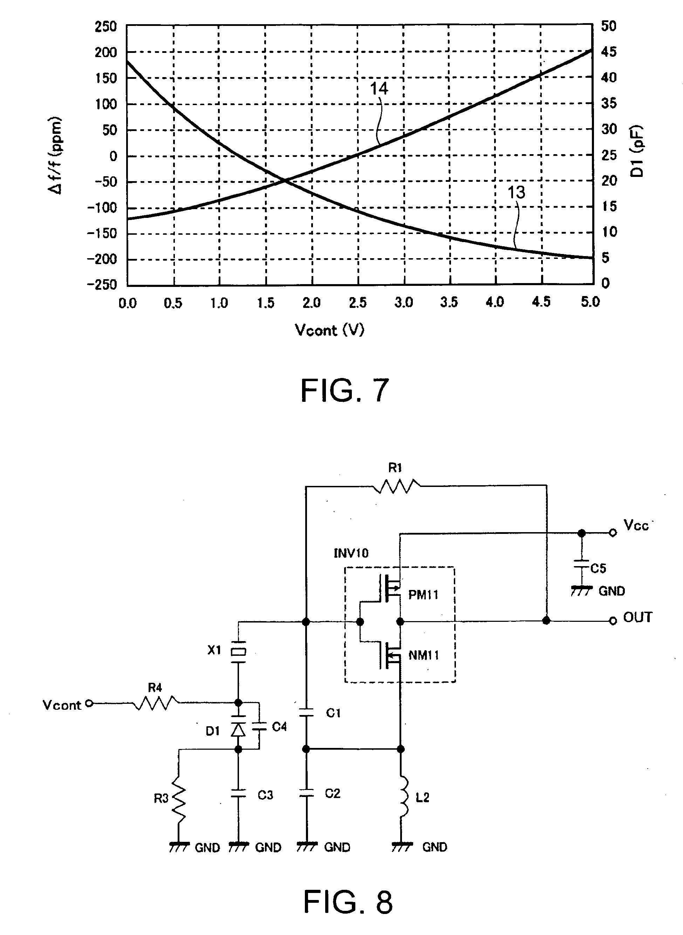

A specific example according the embodiment of the invention will next be described. Fig. 5 illustrates a voltage controlled type quartz crystal oscillator using the oscillation circuit shown in Fig. 1. The frequency adjustment circuit Cv inserted and connected between the quartz crystal resonator X1 and the ground GND includes a series circuit that includes a parallel circuit having the variable capacity diode D1 with a capacitance varying by application of direct-current (DC) voltage and the capacitor C4 and a parallel circuit having the resistor R3 and a load capacitor C3, wherein an external control voltage Vcont is applied to the variable capacity diode D1 through a resistor R4 to make the oscillation frequency of the quartz crystal oscillator variable. The simulation for the circuit constant of the quartz crystal oscillation circuit is performed, provided that resistor R1 = R3 = R4 = 100 kΩ, R2 = 1 kΩ, capacitor C1 = C2 = C3 = 100 pF, C4 = 4pF, C5 = 1 μF, power supply voltage Vcc = +5V, MA2S304 is used as the variable capacity diode D1, a commonly used CMOS inverter as the inverter amplifier, and 13 MHz as the resonance frequency of the quartz crystal resonator. The results of the simulation are shown in Figs. 6 and 7.

In Fig. 6, characteristics 11 indicate circuit negative resistance characteristics with respect to oscillation frequency, and characteristics 12 indicate circuit capacity characteristics with respect to oscillation frequency; in Fig. 7, characteristics 13 indicate capacity characteristics of the variable capacity diode D1 with respect to the external control voltage Vcont, and characteristics 14 indicate frequency variable characteristics with respect to the external control voltage Vcont. It can be seen from Fig. 6 that the circuit negative resistance Rn is around -100 Ω and the circuit capacitance Cc is 16.5 pF in the vicinity of an oscillation frequency of 13 MHz, and as a result, this circuit satisfies the oscillation conditions. It also can be seen from Fig. 7 that the frequency variation df/f ranges from -120 ppm to +200 ppm when the external frequency control voltage Vcont is varied by ±2.5 V, and as a result, this oscillation circuit functions sufficiently as a voltage controlled type quartz crystal oscillator VCXO in which the frequency is made variable by the external voltage.

As described above, a quartz crystal oscillator is configured such that an inverter amplifier formed in a CMOS structure and a first impedance including a parallel connection having a resistor and a load capacitor constitute a connection circuit that is inserted between the power supply and the ground, a series circuit including a quartz crystal resonator and a frequency adjustment circuit is inserted between the input and the ground of the inverter amplifier, a second impedance including a load capacitor is serially inserted and connected between the input of the inverter amplifier and a connecting point of the inverter amplifier and the first impedance, and a resistor is connected between the input and output of the inverter amplifier, allowing the oscillation to operate with the drive level of the quartz crystal resonator suppressed. Frequency variations due to the effect of the output load can also be suppressed without a buffer circuit in the latter part of the oscillation circuit, enabling a small-sized quartz crystal oscillator to be configured in a simple structure.

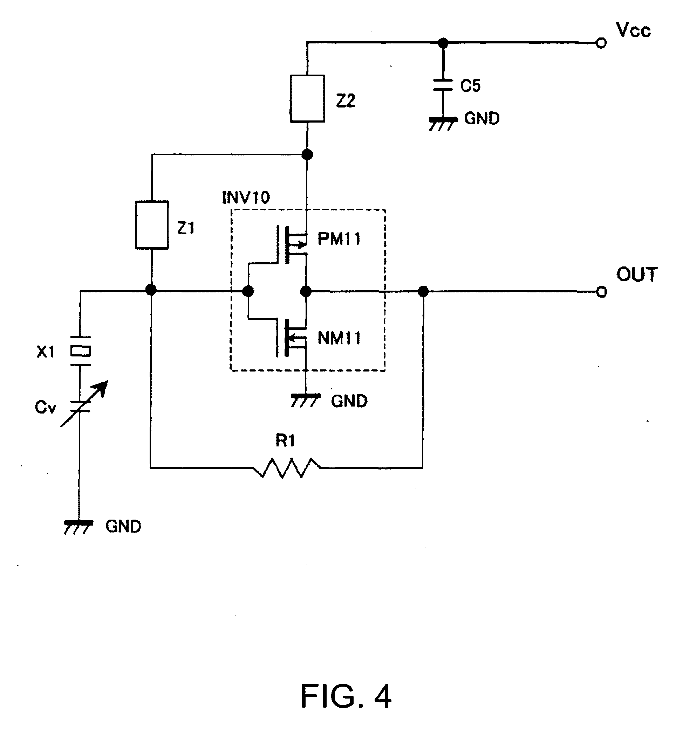

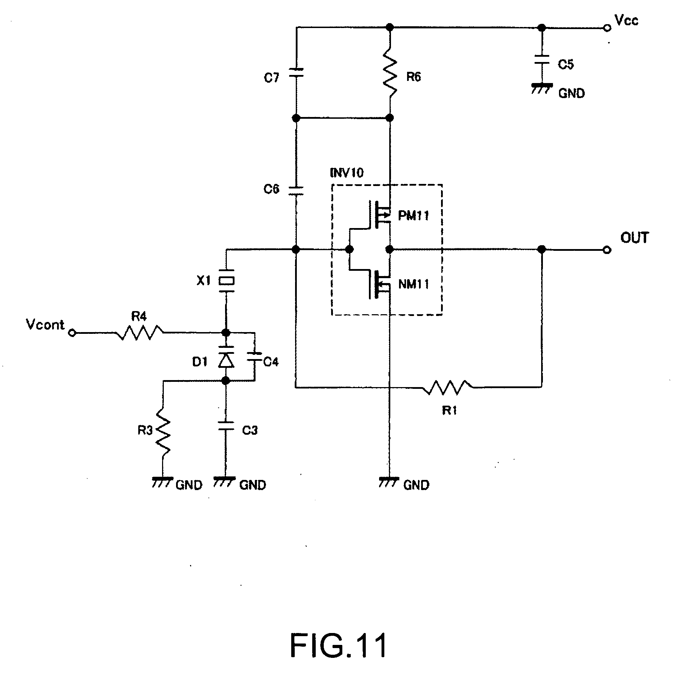

While the first load impedance Z2 is connected between the source of the N type MOS transistor constituting the inverter amplifier and the ground GND as shown in Fig. 1 in this embodiment, the first load impedance Z2 connected between the drain of the P type MOS transistor and the power supply Vcc as shown in Fig. 4 has the same effect as in this embodiment; the quartz crystal oscillation circuit shown in Fig. 11 can also provide characteristics equivalent to those in the oscillation circuit of this specific example shown in Fig. 5.

Second Embodiment

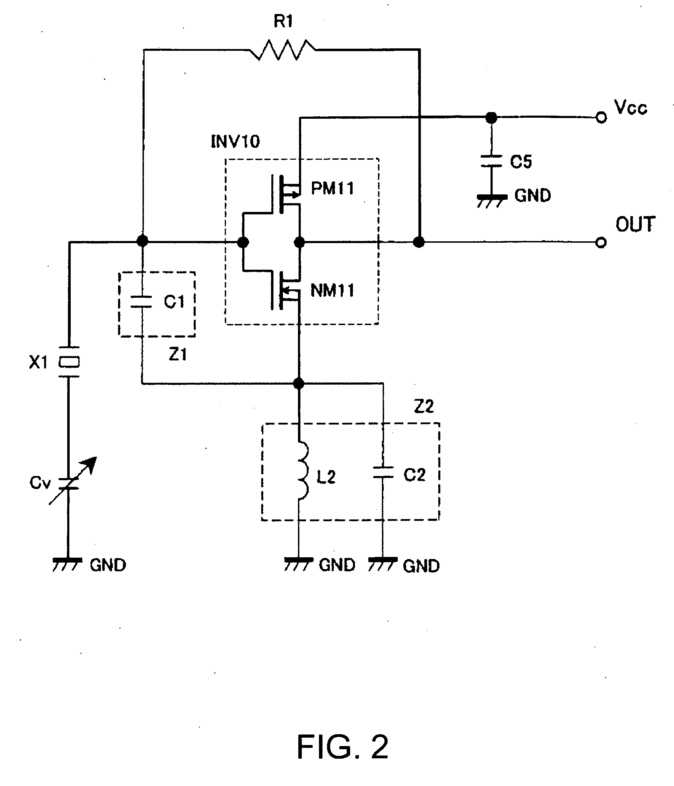

Fig. 2 shows a circuit diagram of a quartz crystal oscillator according to the second embodiment of the invention. The quartz crystal oscillation circuit is characterized in that the first load impedance Z2 of the quartz crystal oscillation circuit of Fig. 1 is replaced by a parallel circuit having an inductor L2 and the load capacitor C2. Note that the other components in the circuit are identical to those shown in Fig. 1, and the same description will not be repeated.

The equivalent circuit shown in Fig. 2 at the start-up of the oscillation in the quartz crystal oscillation circuit can be shown in Fig. 3 in the same manner as the circuit shown in Fig. 1. If Kirchhoff's law is applied in the equivalent circuit shown in Fig. 3, equations (1), (2), and (3) are obtained as described above. Here, the second impedance Z1 is the capacitive reactance C1 as can be seen from Fig. 2, and therefore can be represented by equation (4). At this point, first impedance Z2 also acts as capacitive reactance to have negative resistance. Z2 includes the inductor L2 and the capacitor C2 connected in parallel, and therefore the impedance of Z2 and the resonance frequency of L2 and C2 are expressed by equations (10) and (11).

$$Z_2 = \frac{j w L_2}{1 - \frac{w^2}{w_2{}^2}{}_1} = \frac{1}{j w C_2} \times \frac{1}{1 - \frac{w_2{}^2}{w^2}} \qquad (10)$$

$$w_2{}^2 = \frac{1}{L_2 C_2} \qquad (11)$$

When equations (4) and (11) are substituted into equation (3),

$$Z_{xt} + \frac{1}{j w}\left(\frac{1}{C_1} + \frac{1}{C_2} \times \frac{1}{1 - \frac{w_2{}^2}{w^2}}\right) - \frac{g_m}{w^2 C_1 C_2}\frac{1}{1 - \frac{w_2{}^2}{w^2}} \qquad (12)$$

At this point, if the impedance and the capacitive component of the circuit seen from the quartz crystal resonator X1 are Rc and Cc, respectively, expression (7) is established and the Rc and Cc are expressed by equations (13) and (14).

$$R_c = - \frac{g_m}{w^2 C_1 C_2}\frac{1}{1 - \frac{w_2{}^2}{w^2}} \qquad (13)$$

$$\frac{1}{C_c} = \frac{1}{C_1} + \frac{1}{C_2} \times \frac{1}{1 - \frac{w_2{}^2}{w^2}} \qquad (14)$$

As described above, for the oscillation conditions of the quartz crystal oscillation circuit, it is indispensable that the impedance of the circuit seen from the quartz crystal resonator includes the negative resistance component and capacitive component. Since expression (7) shows that the circuit shown in Fig. 2 satisfies the oscillation conditions, the circuit functions as the quartz crystal oscillation circuit.

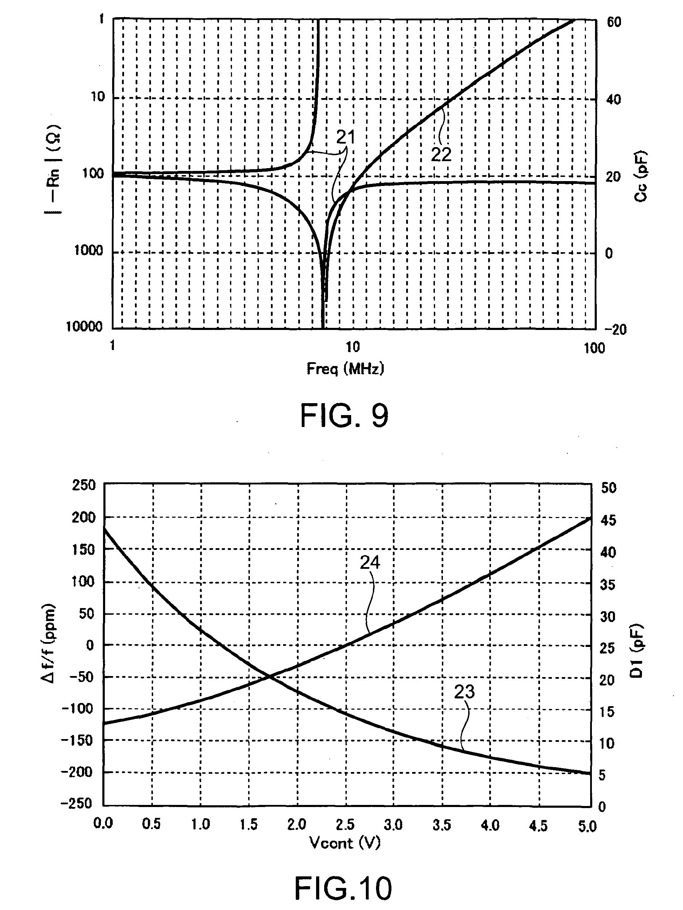

A specific example according to the embodiment of the invention will next be described. Fig. 8 illustrates a voltage controlled type quartz crystal oscillator using the oscillation circuit shown in Fig. 2. Note that, for components identical to those in the first embodiment of the invention, the corresponding description will be omitted. The simulation for the circuit constant of the quartz crystal oscillation circuit is performed, provided that resistor R1 = R3 = R4 = 100 kΩ, capacitor C1= 100 pF, C2 = 200 pF, C3 = 80 pF, C4 = 4 pF, C5 = 1 μF, inductor L2 = 2.2 μH, power supply voltage Vcc = +5V, MA2S304 is used as the variable capacity diode D1, a commonly used CMOS inverter as the inverter amplifier, and 13 MHz as the resonance frequency of the quartz crystal resonator. The results of the simulation are shown in Figs. 9 and 10.

In Fig. 9, characteristics 21 indicate circuit negative resistance characteristics with respect to oscillation frequency, and characteristics 22 indicate circuit capacity characteristics with respect to oscillation frequency; in Fig. 10, characteristics 23 indicate capacity characteristics of the variable capacity diode D1 with respect to the external control voltage Vcont, and characteristics 24 indicate frequency variable characteristics with respect to the external control voltage Vcont. It can be seen from Fig. 9 that the circuit negative resistance Rn is around -110 Ω and the circuit capacitance Cc is 18 pF at an oscillation frequency of 13 MHz, and as a result, this circuit satisfies the oscillation conditions. It also can be seen from Fig. 10 that the frequency variation df/f ranges from -120 ppm to +200 ppm when the external frequency control voltage Vcont is varied by ±2.5 V, and as a result, this oscillation circuit functions sufficiently as the voltage controlled type quartz crystal oscillator VCXO in which the frequency is made variable by the external voltage.

As observed above, in the case where the first impedance is replaced by a parallel circuit including an inductor and a load capacitor, the same effects as in the first embodiment of the invention are obtained, allowing the oscillation to operate with the drive level of the quartz crystal resonator suppressed. Frequency variations due to the effect of the output load can be suppressed without use of a buffer circuit, enabling a small-sized quartz crystal oscillator to be configured in a simple structure.

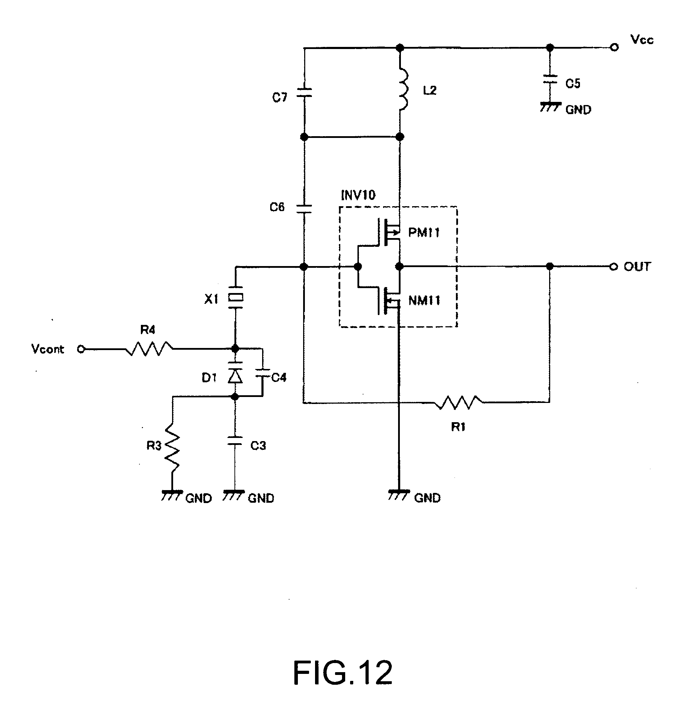

While the first load impedance Z2 is connected between the source of the N type MOS transistor constituting the inverter amplifier and the ground GND as shown in Fig. 2 in this embodiment, the first load impedance Z2 connected between the drain of the P type MOS transistor and the power supply Vcc as shown in Fig. 4 has the same effect as in this embodiment; the quartz crystal oscillation circuit shown in Fig. 12 can also provide characteristics equivalent to those in the oscillation circuit of this specific example shown in Fig. 8.

Third Embodiment

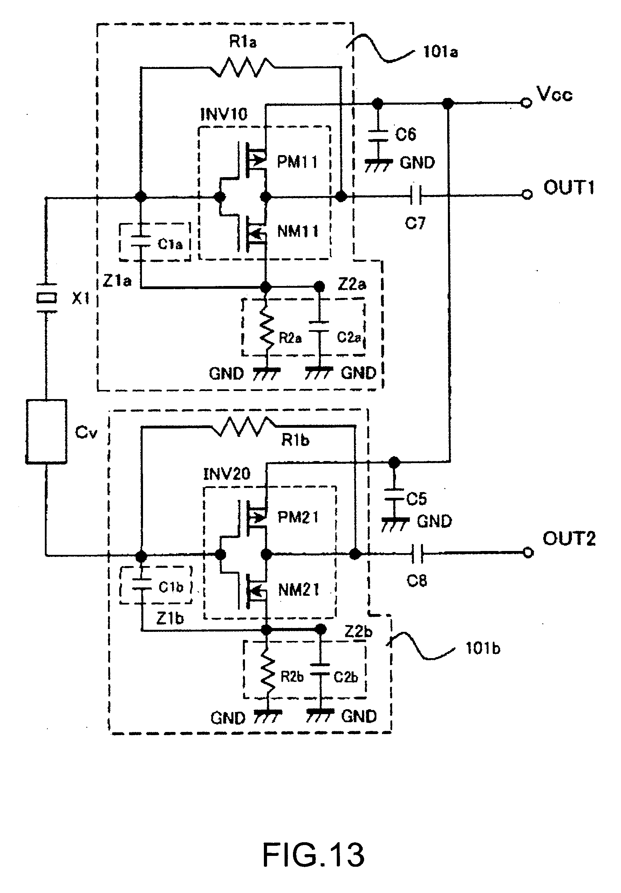

Fig. 13 shows a circuit diagram of a quartz crystal oscillator according to the third embodiment of the invention. Fig. 13 is a diagram illustrating a modification in the first embodiment of the invention, in which a quartz crystal oscillator uses a pair of oscillation circuits including the CMOS inverter amplifier shown in Fig. 1. Note that description on the components identical to those in Fig. 1 will be omitted.

In Fig. 13, the quartz crystal oscillator 105 is configured such that a series circuit of the quartz crystal resonator X1 and the frequency adjustment circuit Cv is inserted between the input of the inverter amplifier INV10 included in a first oscillation circuit 101a and the input of the second inverter amplifier INV20 included in a second oscillation circuit 101b. A first load impedance Z2a that is included in the first oscillation circuit 101a and includes a parallel circuit having a load capacitor C2a and a resistor R2a is identical to a fourth load impedance Z2b that is included in the second oscillation circuit 101b and includes a parallel circuit having a load capacitor C2b and a resistor R2b, a second load impedance Z1a that is included in the first oscillation circuit 101a and includes a load capacitor C1a to a fourth load impedance Z1b that is included in the second oscillation circuit 101b and includes a load capacitor C1b, and a feedback resistor R1a constituting the first oscillation circuit 101a to a feedback resistor R1b constituting the second oscillation circuit 101b.

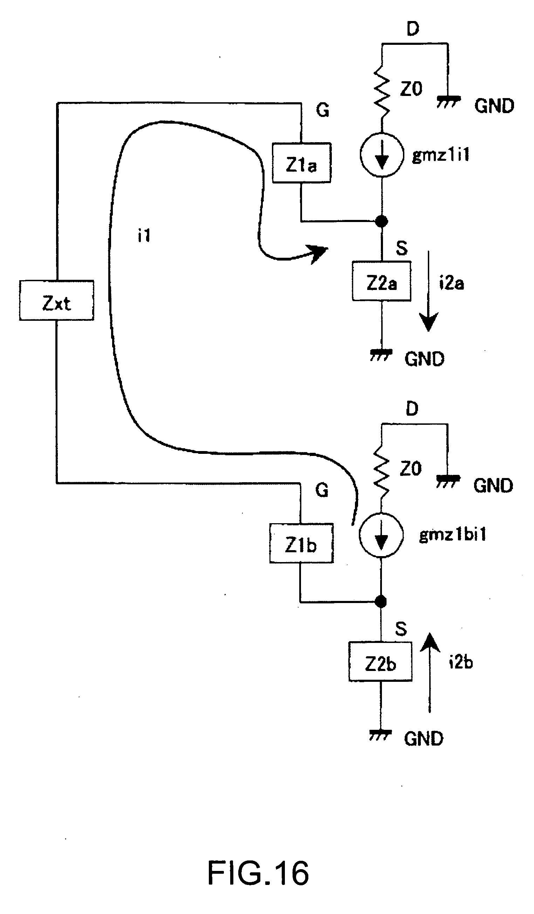

The principle of operation of the quartz crystal oscillation configured in this manner will be described below. Fig. 16 illustrates an equivalent circuit where in the quartz crystal oscillation circuit shown in Fig. 13, the impedance in a series circuit of the quartz crystal resonator X1 and the frequency adjustment circuit Cv is Zxt, the current flowing through the impedance Zxt and the load impedances Z1a and Z1b is i1 the current flowing through the first load impedance Z2a is i2a, and the current flowing through the third load impedance Z2b is i2b. When oscillation is started in the quartz crystal oscillation circuit shown in Fig. 13, a positive electric potential is applied between the gate and source of each of the N type MOS transistor NM11 and the P type MOS transistor PM11 that constitute the first inverter amplifier INV10. Therefore, the N type MOS transistor NM11 functions as a constant current source gmZ1ai1, and the P type MOS transistor PM11 can be regarded as the low impedance Z0 having a resistance of approximately 0. The inverter amplifier INV10 can thereby be replaced by a series circuit of the constant current source gmZ1ai1 and the impedance Z0. Moreover, the above-described phenomenon occurs also in the second inverter amplifier INV20 in the same manner as in the inverter amplifier INV10, and thereby the inverter amplifier INV20 can be replaced by a series circuit of the constant current source gmZ1bi1 and the impedance Z0 having a resistance of approximately 0.

If Kirchhoff's first law is applied in the circuit shown in Fig. 16, equations (15) and (16) are obtained.

$$i_{2a} = i_1 + g_m z_{1a} i_1 \qquad (15)$$

$$i_{2b} = i_1 + g_m z_{1b} i_1 \qquad (16)$$

8

Similarly, if Kirchhoff's second law is applied, the following equation is obtained.

$$z_{2b}i_{2b} + z_{1b}i_1 + z_{xt}i_1 + z_{1a}i_1 + z_{2a}i_{2b} = 0 \qquad (17)$$

When equation (16) is substituted into equation (17),

$$z_{xt} + z_{2b} + z_{2a} + z_{1b} + z_{1a} + g_m(z_{1b}z_{2b1} + z_{1a}z_{2a}) = 0 \qquad (18)$$

where Z1a is identical to Z1b and Z2a is identical to Z2b as described above. Therefore, Z1a = Z1b =Za and Z2a = Z2b = Z2 are substituted into equation (18). The result is as follows:

$$z_{xt} + 2z_1 + 2z_2 + 2g_m z_1 z_2 = 0 \qquad (19)$$

Equation (19) that indicates the oscillation conditions is obtained.

The impedance between the gate and source of a MOS transistor is so high that it can be regarded as approximately ∞, and therefore the impedance of the circuit depends on the load impedances Z1a and Z1b, that is, Za mentioned above. Here, the load impedances Z1a and Z1b constituting the quartz crystal oscillation circuit shown in Fig. 13 are the same capacitive reactance as described above, and therefore if C1a = C2a = C1, the load impedances Z1a and Z1b can be expressed by equation (20). At this point, the load impedances Z2a and Z2b act as capacitive reactance to have negative resistance. Here, the load impedances Z2a and Z2b are parallel circuits each including a resistor and a capacitor and thus are the same, and therefore if C2a = C2b = C2 and R1a = R2a = R2, the impedance is expressed by equation (21).

$$z_{1a} = z_{1b} = z_1 = \frac{1}{jwc_1} \qquad (20)$$

$$z_{2a} = z_{2b} = z_2 = R_2 + \frac{1}{jwc_2} \qquad (21)$$

When equations (20) and (21) are substituted into equation (19), the following equation is obtained.

$$z_{xt} + 2(R_2 - \frac{g_m}{w^2 c_1 c_2}) + \frac{2}{jw}(\frac{1 + g_m R_2}{c_1} + \frac{1}{c_2}) = 0 \qquad (22)$$

At this point, letting Rc and Cc be the impedance and the circuit capacitive component, respectively, of the circuit seen from the quartz crystal resonator X1, expression (23) is obtained and Rc and Cc are expressed by equations (24) and (25).

$$z_{xt} + R_c + \frac{1}{jwc_c} \qquad (23)$$

$$R_c = 2(R_2 - \frac{g_m}{w^2 c_1 c_2}) \qquad (24)$$

$$\frac{1}{c_c} = 2(\frac{1 + g_m R_2}{c_1} + \frac{1}{c_2}) \qquad (25)$$

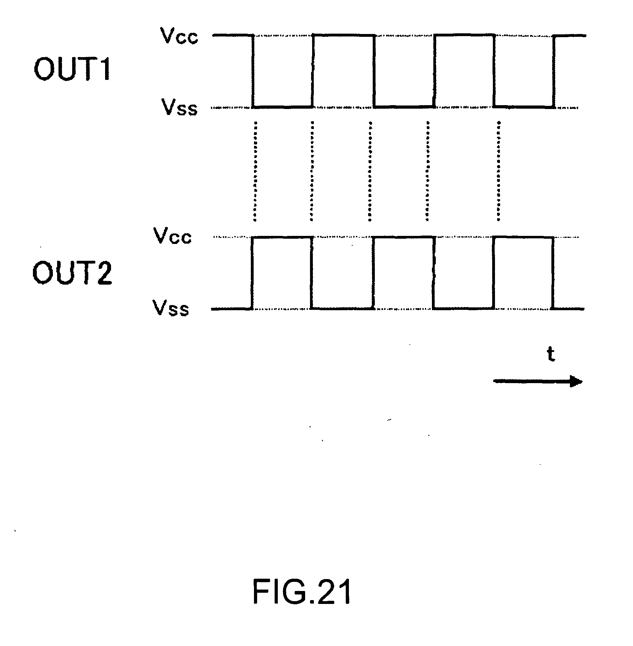

As known, for the oscillation conditions of the quartz crystal oscillation circuit, it is indispensable that the impedance of the circuit seen from the quartz crystal resonator includes the negative resistance component and capacitive component. Since expression (23) shows that the circuit shown in Fig. 13 satisfies the oscillation conditions, the circuit functions as the quartz crystal oscillation circuit. As obvious from the equivalent circuit shown in Fig. 16, the current i2a flowing through the first load impedance Z2a and the current i2b flowing through the third load impedance Z2b are always in opposite directions, and therefore the phases of the outputs in the inverter amplifiers always shift by 180 degrees as shown in Fig. 21. Thus, the quartz crystal oscillation circuit shown in Fig. 13 can provide two output signals that differ in their phases by 180 degrees.

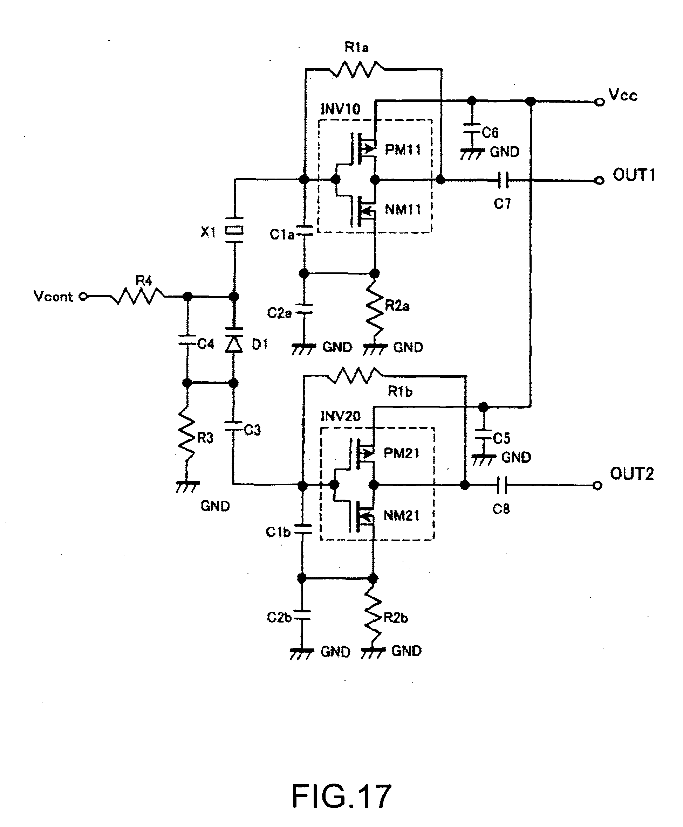

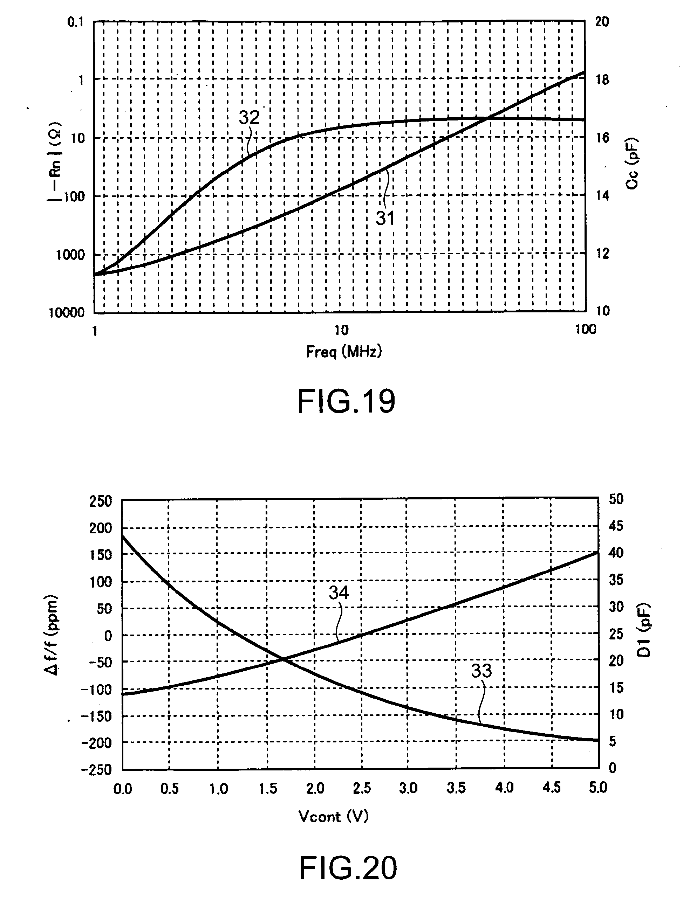

A specific example according to the embodiment of the invention will next be described. Fig. 17 illustrates a voltage controlled type quartz crystal oscillator using the oscillation circuit shown in Fig. 13. The simulation for the circuit constant of the quartz crystal oscillation circuit is performed, provided that resistor R1 = R1a = R1b = R3 = R4 = 100 k$\Omega$, R2 = R2a = R2b = 1 k$\Omega$, capacitor C1= C1a = C1b = 40 pF, C2 = C2a = C2b = 100 pF, C5 = C6 = 0.1 $\mu$F, power supply voltage Vcc = +5V, MA2S304 is used as the variable capacity diode D1, a commonly used CMOS inverter as the inverter amplifier, and 13 MHz as the resonance frequency of the quartz crystal resonator. The results of the simulation are shown in Figs. 19 and 20.

In Fig. 19, characteristics 31 indicate circuit negative resistance characteristics with respect to oscillation frequency, and characteristics 32 indicate circuit capacity characteristics with respect to oscillation frequency; in Fig. 20, characteristics 33 indicate capacity characteristics of the variable capacity diode D1 with respect to the external control voltage Vcont, and characteristics 34 indicate frequency variable characteristics with respect to the external control voltage Vcont. It can be seen from Fig. 19 that the circuit negative resistance Rn is around -90 $\Omega$ and the circuit capacitance Cc is 16.5 pF in the vicinity of an oscillation frequency of 13 MHz, and as a result, this circuit satisfies the oscillation conditions. It also can be seen from Fig. 20 that the frequency variation df/f ranges from -100 ppm to +150 ppm when the external frequency control voltage Vcont is varied by $\pm$2.5 V, and as a result, this oscillation circuit functions sufficiently as the voltage controlled type quartz crystal oscillator VCXO in which the frequency is made variable by the external voltage.

As described above, the quartz crystal oscillator is configured using a pair of oscillation circuits that use the inverter amplifier with CMOS structure shown in Fig. 1 such that a series circuit of a quartz crystal resonator and a frequency adjustment circuit is inserted between the input of an inverter amplifier constituting a first oscillation circuit and a second inverter amplifier constituting a second oscillation circuit, thereby allowing the oscillation to operate with the drive level of the quartz crystal resonator suppressed. Frequency variations due to the effect of the output load can be suppressed without use of a buffer circuit, enabling a small-sized quartz crystal oscillator to be configured in a simple structure. Moreover, two oscillation outputs derived from the quartz crystal oscillator can completely maintain a phase difference of 180 degrees, and therefore makes it possible to provide a quartz crystal oscillator suitable for high-speed data transmission. If a receiver driver with a common differential amplifier structure is used in the latter part of the quartz crystal oscillation circuit, it is also possible to provide, for example, a low noise oscillator from which common mode noise occurring in the oscillation circuit is removed.

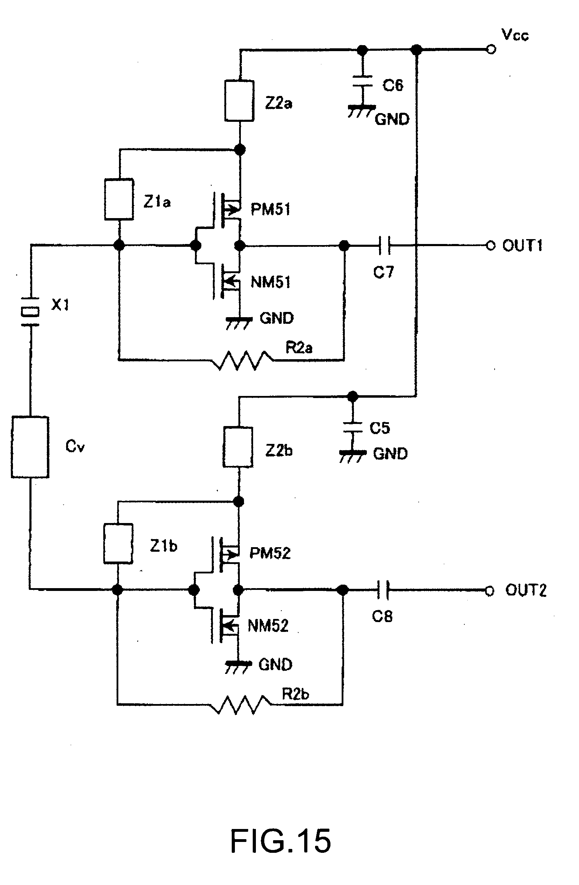

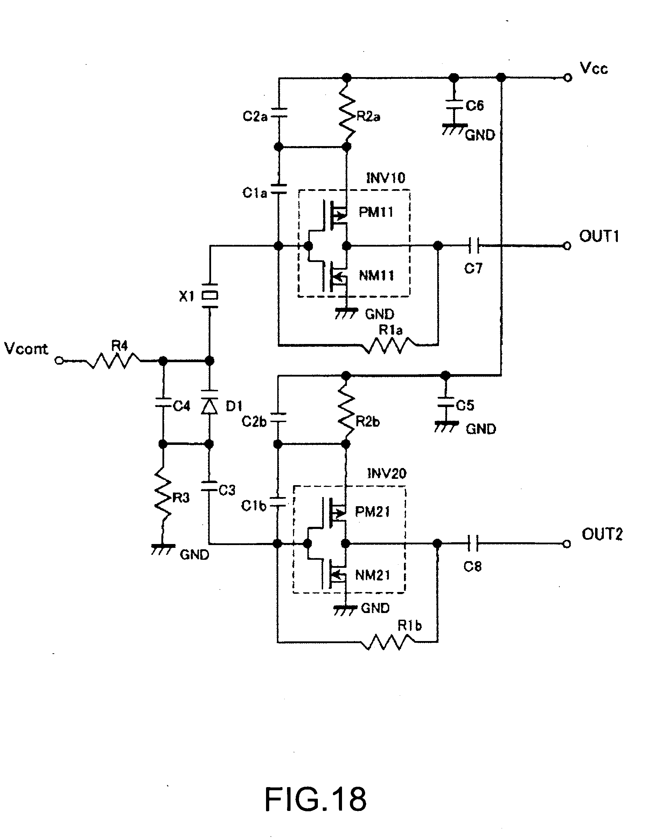

While each of the load impedances Z2a and Z2b is connected between the source of the N type MOS transistor constituting the inverter amplifier and the ground GND as shown in Fig. 13 in this embodiment, each of the load impedances connected between the drain of the P type MOS transistor and the power supply Vcc as shown in Fig. 15 has the same effect as in this embodiment; the quartz crystal oscillation circuit shown in Fig. 18 can also provide characteristics equivalent to those in the oscillation circuit of this specific example.

Fourth Embodiment

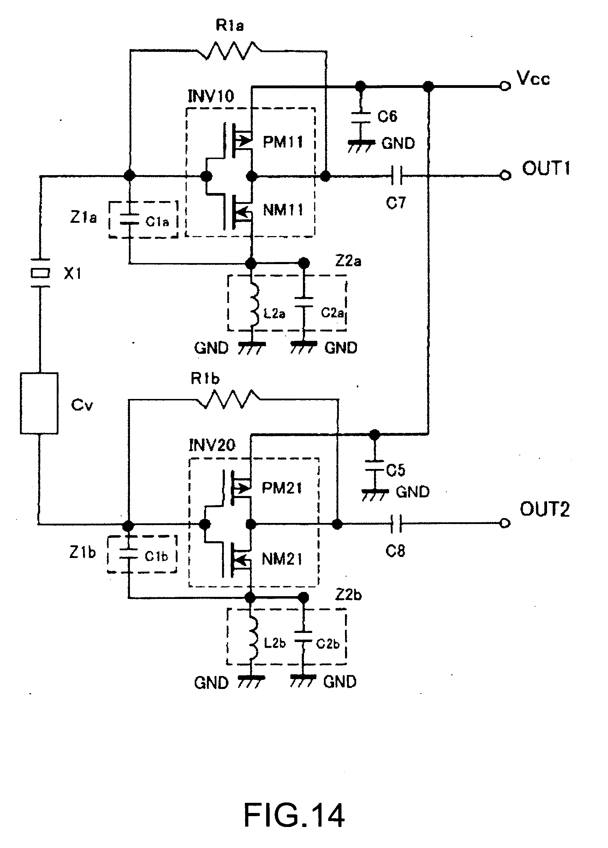

Fig. 14 shows a circuit diagram of a quartz crystal oscillator according to the fourth embodiment of the invention. Fig. 14 is a diagram illustrating a modification in the second embodiment of the invention, that is, a circuit diagram in which a quartz crystal oscillator uses a pair of oscillation circuits each including the CMOS inverter amplifier shown in Fig. 2. The quartz crystal oscillation circuit is characterized in that the load impedances Z2a and Z2b shown in Fig. 13 are replaced by parallel circuits each including a load capacitor and an inductor and the load capacitors and inductors constituting the two circuits are the same. Note that the other components in the circuit are identical to those in the modification of the first embodiment, and the same description will not be repeated.

The principle of operation of the quartz crystal oscillation shown in Fig. 14 will be described below. The equivalent circuit at oscillation start-up of the quartz crystal oscillation circuit shown in Fig. 14 can be shown in Fig. 16 in the same manner as in Fig. 13. If Kirchhoff's law is applied in the equivalent circuit shown in Fig. 16, equation (18) is obtained as described above. The load impedance Z1a is identical to Z1b and the load impedance Z2a is identical to Z2b in the same manner as in the first embodiment modification, and therefore letting Z1a = Z1b = Za and Z2a = Z2b =Z2b, substitution of them into equation (19) yields equation (19) that indicates oscillation conditions.

As described above, the impedance between the gate and source of a MOS transistor is so high that it can be regarded as approximately ∞, and therefore the impedance of the circuit depends on the load impedances Z1a and Z1b, that is, Za mentioned above. Here, the load impedances Z1a and Z1b constituting the quartz crystal oscillation circuit shown in Fig. 14 are the same capacitive reactance as described above, and therefore if C1a = C2a = C1, the load impedances Z1a and Z1b can be expressed by equation (20). At this point, the load impedances Z2a and Z2b act as capacitive reactance to have negative resistance. Here, the load impedances Z2a and Z2b are parallel circuits each including an inductor and a capacitor and thus are the same, and therefore if L2a = L2b = L2 and C2a = C2b = C2, the impedance is given by equation (26) and resonance frequency of L2 and C2 is expressed by equation (11).

$$Z_{2a} = Z_{2b} = Z_2 = \frac{j w L_1}{1 - \frac{w^2}{w_2^2}_1} = \frac{1}{j w C_2} \times \frac{1}{1 - \frac{w_2^2}{w^2}} \quad (26)$$

When equations (11), (20), and (26) are substituted into equation (19),

$$Z_{xt} + \frac{2}{jw}(\frac{1}{C_1} + \frac{1}{C_2} \times \frac{1}{1 - \frac{w_2^2}{w^2}}) - \frac{2g_m}{w^2 C_1 C_2} \frac{1}{1 - \frac{w_2^2}{w^2}} \quad (27)$$

At this point, letting Rc and Cc be the impedance and the circuit capacitive component, respectively, of the circuit seen from the quartz crystal resonator X1, expression (23) is obtained and Rc and Cc are expressed by equations (28) and (29).

$$R_c = -\frac{2g_m}{w^2 C_1 C_2} \frac{1}{1 - \frac{w_2^2}{w^2}} \quad (28)$$

$$\frac{1}{C_c} = \frac{2}{C_1} + \frac{2}{C_2} \times \frac{1}{1 - \frac{w_2^2}{w^2}} \quad (29)$$

As described above, for the oscillation conditions of the quartz crystal oscillation circuit, it is indispensable that the impedance of the circuit seen from the quartz crystal resonator includes the negative resistance component and capacitive component. Since expression (23) shows that the circuit shown in Fig. 14 satisfies the oscillation conditions, the circuit functions as the quartz crystal oscillation circuit.

As obvious from the equivalent circuit shown in Fig. 16, the current i2a flowing through the first load impedance Z2a and the current i2b flowing through the third load impedance Z2b are always in opposite directions, and therefore the phases of the outputs in the inverter amplifiers always shift by 180 degrees as shown in Fig. 21. Thus, the quartz crystal oscillation circuit shown in Fig. 14 can provide two output signals that differ in their phases by 180 degrees.

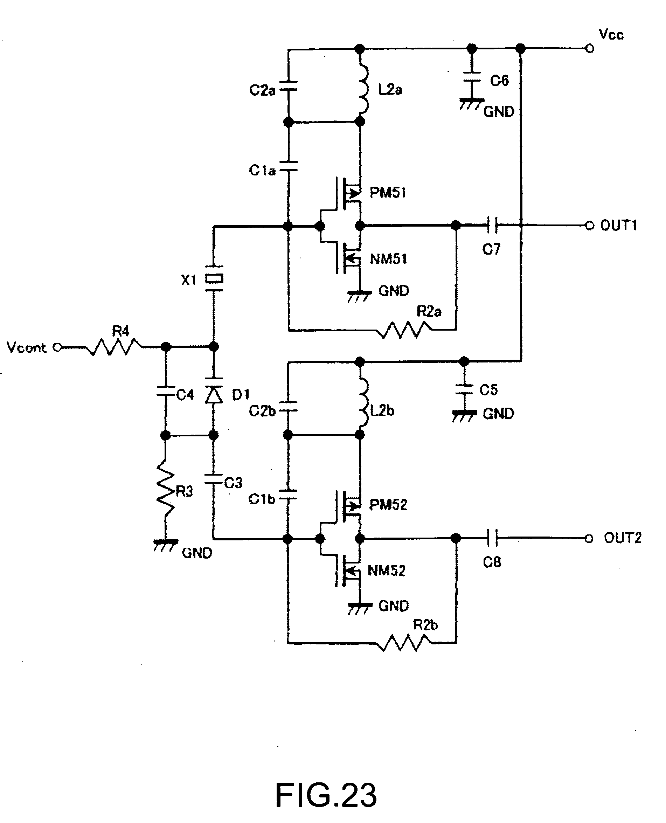

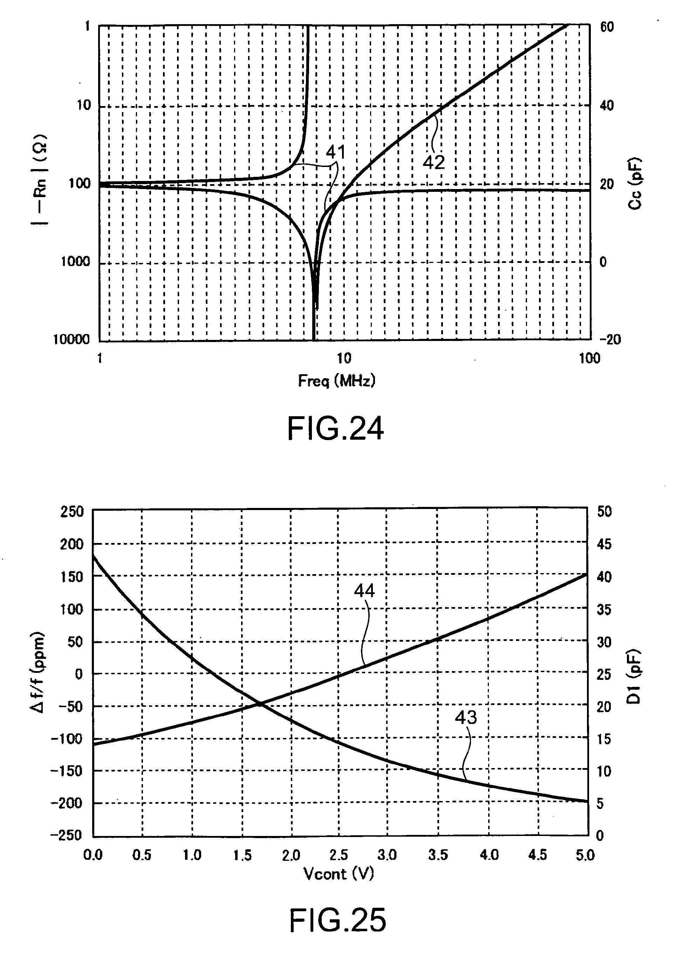

A specific example according to the embodiment of the invention will next be described. Fig. 23 illustrates a voltage controlled type quartz crystal oscillator using the oscillation circuit shown in Fig. 14. The simulation for the circuit constant of the quartz crystal oscillation circuit is performed, provided that resistor R1a = R1b = R3 = R4 = 100 kΩ, inductor L2a = L2b = 2.2 μH, capacitor C1a = C1b = 40 pF, C2a = C2b = 100 pF, C5 = C6 = 1 μF, power supply voltage Vcc = +5V, MA2S304 is used as the variable capacity diode D1, a commonly used CMOS inverter as the inverter amplifier, and 13 MHz as the resonance frequency of the quartz crystal resonator. The results of the simulation are shown in Figs. 24 and 25.

In Fig. 24, characteristics 41 indicate circuit negative resistance characteristics with respect to oscillation frequency, and characteristics 42 indicate circuit capacity characteristics with respect to oscillation frequency; in Fig. 25, characteristics 43 indicate capacity characteristics of the variable capacity diode D1 with respect to the external control voltage Vcont, and characteristics 44 indicate frequency variable characteristics with respect to the external control voltage Vcont. It can be seen from Fig. 24 that the circuit negative resistance Rn is around -100 $\Omega$ and the circuit capacitance $C_L$ is 19 pF in the vicinity of an oscillation frequency of 13 MHz, and as a result, this circuit satisfies the oscillation conditions. It also can be seen from Fig. 19 that the frequency variation df/f ranges from -100 ppm to +150 ppm when the external frequency control voltage Vcont is varied by $\pm 2.5$ V, and as a result, this oscillation circuit functions sufficiently as the voltage controlled type quartz crystal oscillator VCXO in which the frequency is made variable by the external voltage.

As described above, the quartz crystal oscillator is configured using a pair of oscillation circuits that use the inverter amplifier with CMOS structure shown in Fig. 2 such that a series circuit of a quartz crystal resonator and a frequency adjustment circuit is inserted between the input of an inverter amplifier constituting a first oscillation circuit and a second inverter amplifier constituting a second oscillation circuit, thereby allowing the same effects as in the first embodiment modification of the invention to be obtained.

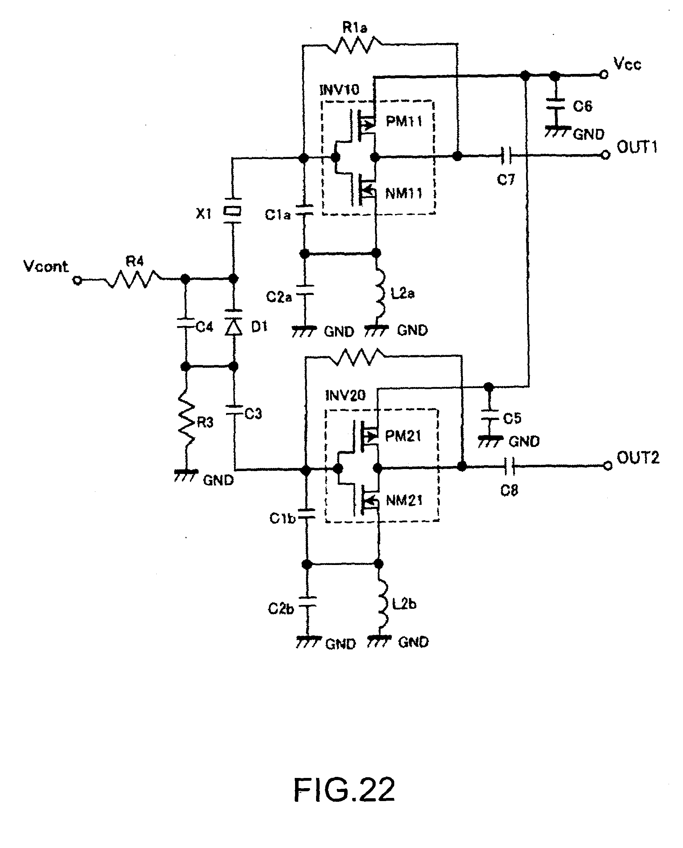

While each of the load impedances Z1a and Z1b is connected between the source of the N type MOS transistor constituting the inverter amplifier and the ground GND as shown in Fig. 14 in this embodiment, the load impedances connected between the drain of the P type MOS transistor and the power supply Vcc as shown in Fig. 15 has the same effect as in this embodiment; the quartz crystal oscillation circuit shown in Fig. 23 can provide characteristics equivalent to those in the oscillation circuit of this specific example shown in Fig. 22.

The present invention is not limited to the above-described embodiments, in which description is given using a voltage controlled type quartz crystal oscillator as an example. Quartz crystal oscillators of temperature compensated type, thermostat controlled type, and the like and piezoelectric oscillators using piezoelectric resonators other than quartz crystal produce the same effects as the voltage controlled type quartz crystal oscillator.

**Claims**

1. A piezoelectric oscillator, comprising:

   an inverter amplifier;
   a first load impedance constituting together with the inverter amplifier a connection circuit that is inserted between a power supply and a ground;
   a piezoelectric resonator being inserted between an input of the inverter amplifier and the ground;
   a second load impedance being serially inserted and connected between the input of the inverter amplifier and a connecting point of the inverter amplifier and the first load impedance; and
   a resistor being connected between the input and an output of the inverter amplifier.

2. The piezoelectric oscillator according to claim 1, wherein the inverter amplifier has a CMOS structure including a P channel type MOS-FET and an N channel type MOS-FET connected in series.

3. The piezoelectric oscillator according to claim 1, wherein the first load impedance includes a parallel circuit having a load capacitor and a resistor, and the second load impedance includes a capacitor.

4. The piezoelectric oscillator according to claim 1, wherein the first load impedance includes a parallel circuit having a load capacitor and an inductor, and the second load impedance includes a capacitor.

5. A piezoelectric oscillator, comprising:

   a first inverter amplifier;
   a first load impedance constituting together with the first inverter amplifier a connection circuit;
   a second inverter amplifier;
   a third load impedance constituting together with the second inverter amplifier a connection circuit that is connected in parallel with the connection circuit including the first load impedance and the first inverter amplifier between a power supply and a ground;
   a second load impedance being serially inserted and connected between an input of the first inverter amplifier and a connecting point of the first inverter amplifier and the first load impedance;
   a fourth load impedance being serially inserted and connected between an input of the second inverter amplifier and a connecting point of the second inverter amplifier and the third load impedance;

a resistor being inserted between the input and an output of each of the first and second inverter amplifiers; and a piezoelectric resonator being inserted between the input of the first inverter amplifier and the input of the second inverter amplifier.

6. The piezoelectric oscillator according to claim 5, wherein the inverter amplifier has a CMOS structure including a P channel type MOS-FET and an N channel type MOS-FET connected in series.

7. The piezoelectric oscillator according to claim 5, wherein the first and third load impedances include parallel circuits each having a load capacitor and an inductor, and the second and fourth load impedances each include a capacitor.

8. The piezoelectric oscillator according to claim 5, wherein the first and third load impedances include parallel circuits each having a load capacitor and a resistor, and the second and fourth load impedances each include a capacitor.

9. The piezoelectric oscillator according to claim 2, further comprising a frequency adjustment unit that is inserted in series with the piezoelectric resonator.

FIG. 1

FIG. 2

FIG. 3

FIG. 4

FIG. 5

FIG. 6

FIG. 7

FIG. 8

FIG. 9

FIG.10

FIG.11

FIG.12

FIG.13

FIG.14

FIG.15

FIG.16

FIG.17

FIG.18

FIG.19

FIG.20

OUT1

Vcc

Vss

OUT2

Vcc

Vss

t

FIG.21

**FIG.22**

FIG.23

FIG.24

FIG.25

FIG.26

FIG.27

FIG.28

**European Patent Office**

**EUROPEAN SEARCH REPORT**

Application Number

EP 06 00 5186

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/189413 A1 (SATOH TOMIO) 30 September 2004 (2004-09-30) * abstract; figure 3 * | 1-4,9 | INV. H03B5/36 H03K3/03 |
| Y | | 5-8 | |
| Y | US 5 920 234 A (HILL ET AL) 6 July 1999 (1999-07-06) * column 3, lines 25-65; figure 1 * | 5-8 | |
| X | US 3 581 240 A (RALPH T. ENDERBY) 25 May 1971 (1971-05-25) * abstract; figure * | 1,3,4 | |
| A | | 9 | |
| X | US 3 845 410 A (STEEL F,US) 29 October 1974 (1974-10-29) * abstract; figure * | 1,3,4 | |
| A | | 9 | |

TECHNICAL FIELDS SEARCHED (IPC)

H03B
H03K

The present search report has been drawn up for all claims

| Place of search | Date of completion of the search | Examiner |
|---|---|---|
| Munich | 7 August 2006 | Robinson, V |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 06 00 5186

This annex lists the patent family members relating to the patent documents cited in the above-mentioned European search report.
The members are as contained in the European Patent Office EDP file on
The European Patent Office is in no way liable for these particulars which are merely given for the purpose of information.

07-08-2006

| Patent document cited in search report | Publication date | Patent family member(s) | Publication date |
|---|---|---|---|
| US 2004189413 A1 | 30-09-2004 | NONE | |
| US 5920234 A | 06-07-1999 | NONE | |
| US 3581240 A | 25-05-1971 | DE 2000703 A1<br>IL 33643 A<br>KR 7800341 A | 23-07-1970<br>30-01-1973<br>11-09-1978 |
| US 3845410 A | 29-10-1974 | NONE | |

EPO FORM P0459

For more details about this annex : see Official Journal of the European Patent Office, No. 12/82